# FASCICULE DE BREVET EUROPEEN

(11) **EP 1 329 954 B1**
(45) Date de publication et mention de la délivrance du brevet: **15.03.2017**
(21) Numéro de dépôt: 03290028.4
(22) Date de dépôt: 07.01.2003
(51) Int. Cl.: H01L 27/14, H01L 21/04, H01L 29/24, H03K 17/78, H01L 25/16

(54) **Convertisseur matriciel pour la transformation d'énergie électrique**
Matrixumrichter zur Umwandlung elektrischer Energie
Matrixconverter for transforming electrical energy

(30) Priorité: 17.01.2002 FR 0200552
(43) Date de publication de la demande: 23.07.2003
(73) Titulaire: ALSTOM Transport Technologies, 93400 Saint-Ouen (FR)
(72) Inventeur: Dutarde, Emmanuel, 64800 Mirepeix (FR); Beuille, Christophe, 65800 Aureilhan (FR); Breit, Fabrice, 65710 Campan (FR); Schneider, Henri, 31071 Toulouse Cedex 7 (FR)
(74) Mandataire: Lavoix

(56) Documents cités:
- WO-A-99/67798
- US-A- 6 140 715
- US-A1- 2001 026 427
- PRASAD R R ET AL: "Optically triggered diamond switches" DIGEST OF TECHNICAL PAPERS. 12TH IEEE INTERNATIONAL PULSED POWER CONFERENCE. (CAT. NO.99CH36358), PROCEEDINGS OF THE 12TH INTERNATIONAL PULSED POWER CONFERENCE, MONTEREY, CA, USA, 27-30 JUNE 1999, pages 142-145 vol.1, XP002223450 1999, Piscataway, NJ, USA, IEEE, USA ISBN: 0-7803-5498-2
- KRISHNAN M ET AL: "Fast opening diamond switch for high voltage, high average power inductive energy store modulators" DIGEST OF TECHNICAL PAPERS. 12TH IEEE INTERNATIONAL PULSED POWER CONFERENCE. (CAT. NO.99CH36358), PROCEEDINGS OF THE 12TH INTERNATIONAL PULSED POWER CONFERENCE, MONTEREY, CA, USA, 27-30 JUNE 1999, pages 1222-1225 vol.2, XP002223451 1999, Piscataway, NJ, USA, IEEE, USA ISBN: 0-7803-5498-2

## Description

L'invention se rapporte à un convertisseur matriciel pour la transformation d'énergie électrique entre une source de tension, telle qu'un réseau d'alimentation, et une source de courant, telle qu'un moteur. L'invention s'applique notamment à la commande des moteurs de traction du domaine ferroviaire.

Il est connu, de la demande de brevet US 2001/0026427 A1, un convertisseur matriciel comportant une matrice 3x3 composée d'interrupteurs bidirectionnels pour l'alimentation d'un moteur asynchrone à partir d'un réseau triphasé. Un tel convertisseur matriciel présente par exemple l'avantage, de part sa topologie modulable, de permettre la conversion directe d'un courant alternatif vers un courant alternatif avec une tension et une fréquence différentes, cette conversion étant effectuée par une simple commande appropriée des différents interrupteurs, alors que les convertisseurs à structure figée habituellement utilisés nécessitent d'associer en série un redresseur AC/DC, un hacheur DC/DC et un onduleur DC/AC combinés avec des capacités de filtrage pour obtenir le même résultat.

Toutefois, dans un tel convertisseur matriciel les interrupteurs bidirectionnels sont constitués par l'association de composants IGBT et de diodes qui présentent l'inconvénient de ne pas résister à des tensions trop importantes, les composants IGBT les plus robustes actuellement disponibles dans le commerce étant limités à une tension de fonctionnement de l'ordre de 6,5 kV. De plus, les composants IGBT présentent l'inconvénient de posséder une grille de commande qui doit être isolée de son collecteur et de son émetteur, ce qui pose des problèmes lorsque la tension aux bornes du composant IGBT devient importante.

Aussi, un but de la présente invention est de proposer un convertisseur matriciel d'un type nouveau qui puisse fonctionner avec de fortes tensions tout en conservant une grande compacité. Un autre but de l'invention est de proposer un convertisseur matriciel dont les interrupteurs présentent une commande qui est naturellement isolée des bornes de l'interrupteur.

A cet effet, l'invention a pour objet un convertisseur matriciel pour la transformation d'énergie électrique entre au moins une source de tension, notamment un réseau d'alimentation, et au moins une source de courant, notamment une charge, le convertisseur comportant une matrice d'interrupteurs reliant les sources de tension aux sources de courant, caractérisé en ce que les interrupteurs comportent chacun deux bornes disposées dans deux plans parallèles distincts et un substrat diamant photoconducteur interposé entre les deux bornes de l'interrupteur, la commande de chaque interrupteur étant réalisée au moyen d'une source optique venant irradier le substrat diamant interposé entre les deux bornes, et en ce que chaque interrupteur du convertisseur est formé par un substrat diamant individuel qui est supporté par un substrat céramique, ce substrat diamant individuel étant lié au substrat céramique support par l'intermédiaire d'une couche de verre.

Selon des modes particuliers de réalisation, le convertisseur matriciel selon l'invention peut comprendre l'une ou plusieurs des caractéristiques suivantes prises isolément ou selon toutes les combinaisons techniquement possibles :
- le substrat diamant est obtenu par un procédé CVD de dépôt chimique en phase vapeur ;
- les bornes sont réalisées par métallisation du substrat diamant par vaporisation successive de Titane-Platine-Or ;
- la source optique est une source ultraviolette ;
- pour chaque interrupteur, la source optique est disposée en face de l'une des deux bornes de l'interrupteur, cette borne comportant au moins une ouverture permettant le passage du rayonnement de ladite source vers le substrat diamant interposé entre les deux bornes .

On comprendra mieux les buts, aspects et avantages de la présente invention, d'après la description donnée ci-après de deux modes de réalisation de l'invention, présentés à titre d'exemple non limitatif, en se référant aux dessins annexés, dans lesquels :
- la figure 1 est un exemple d'une vue en perspective d'un convertisseur matriciel ne faisant pas partie de l'invention ;
- la figure 2 est une vue en perspective simplifiée du convertisseur de la figure 1 montrant l'assemblage des connecteurs d'entrée et de sortie sur le substrat diamant ;
- la figure 3 est une vue de détail, en coupe, d'un interrupteur diamant équipant le convertisseur de la figure 1 ;
- la figure 4 est une vue de détail en perspective de l'interrupteur de la figure 3 ;
- la figure 5 est une vue en perspective de la face supérieure d'un convertisseur matriciel selon l'invention ;
- la figure 6 est une vue en perspective de la face inférieure du convertisseur de la figure 5 ;
- la figure 7 est une vue de détail en perspective d'un interrupteur diamant du convertisseur des figures 5 et 6 ;
- la figure 8 est une vue de détail, en coupe suivant la ligne VIII-VIII, de l'interrupteur de la figure 7.

Pour faciliter la lecture du dessin, seuls les éléments nécessaires à la compréhension de l'invention ont été représentés. Les mêmes éléments portent les mêmes références d'une figure à l'autre. Pour plus de clarté des figures, certains éléments du convertisseur ne sont représentés que sur les vues de détail.

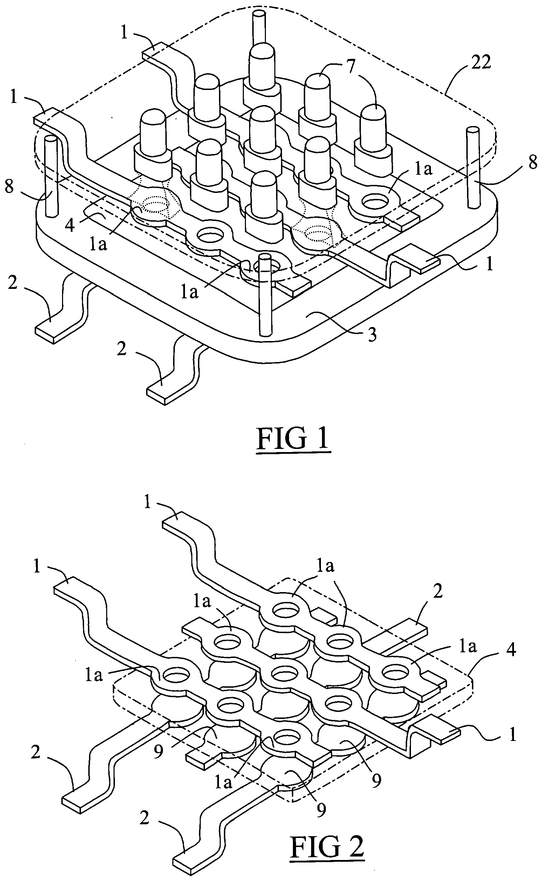

La figure 1 représente un exemple de réalisation particulier d'un convertisseur matriciel , ce convertisseur matriciel comportant trois connecteurs d'entrée destinés par exemple à être alimentés par un réseau triphasé et trois connecteurs de sortie 2 destinés par exemple à fournir de l'énergie à un moteur asynchrone.

Conformément à cette figure, le convertisseur matriciel comporte un socle 3 en matière plastique, de forme sensiblement carrée de 150 mm de côté, supportant en son centre une ouverture débouchant sur les deux faces du socle 3 et dans laquelle est inséré un substrat diamant 4 photoconducteur. Ce substrat diamant 4 est réalisé de façon connue en soi par un procédé de dépôt chimique en phase vapeur, également appelé procédé CVD.

Le substrat diamant 4 comprend une face supérieure qui est au contact des trois connecteurs d'entrée 1, ces derniers étant constitués respectivement par trois barres conductrices disposées en parallèle. Chaque connecteur d'entrée 1 présente une forme générale rectiligne en regard du substrat diamant 4 et comporte localement trois portions annulaires 1a disposées de façon à ce que les portions annulaires la des trois connecteurs d'entrée 1 soient arrangés suivant une matrice 3x3.

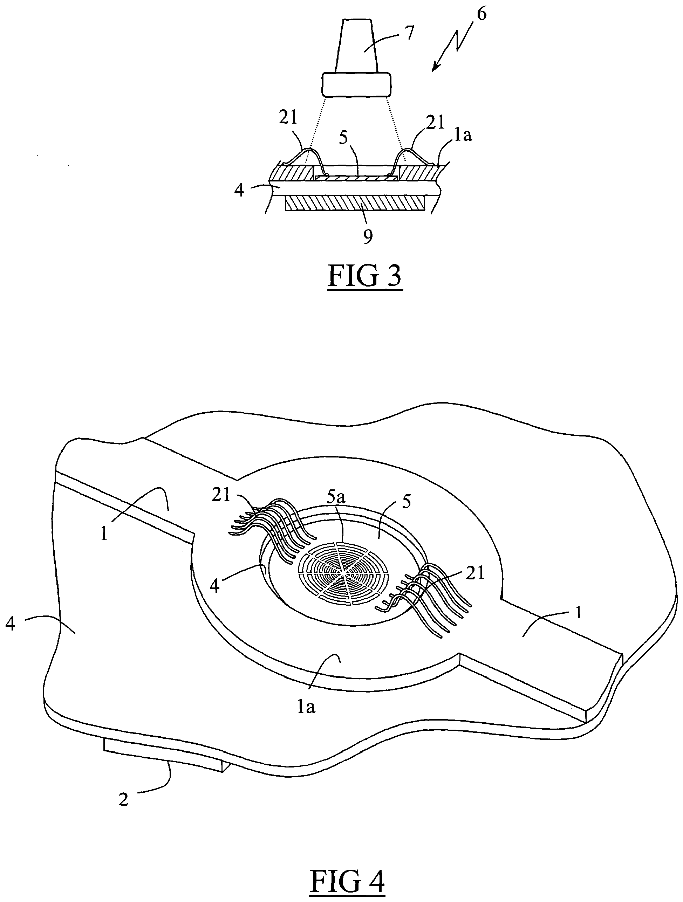

Conformément à la figure 2, où seuls les connecteurs d'entrée 1, de sortie 2 et le substrat diamant 4 sont représentés, la face inférieure du substrat diamant 4 est au contact des trois connecteurs de sortie 2 constitués respectivement par trois barres conductrices disposées en parallèle et orientées perpendiculairement aux trois connecteurs d'entrée 1. Chaque connecteur de sortie 2 présente une forme générale rectiligne en regard du substrat diamant 4 et comporte localement trois renflement en forme de disque 9 disposés de façon à ce que chacun des disques 9 soit en face d'une portion annulaire 1a d'un connecteur d'entrée 1 disposé sur la face opposée du substrat diamant 4, représenté en trait mixte sur la figure 4.

Les figure 3 et 4 représentent plus en détail la constitution d'un interrupteur diamant 6 équipant le convertisseur matriciel. Conformément à ces figures, chaque portion annulaire 1a comporte en son centre une ouverture au niveau de laquelle la face supérieure du substrat diamant 4 est recouverte d'une borne métallisée 5, cette dernière étant représentée uniquement sur ces figures. Cette borne métallisée 5 est connectée électriquement au connecteur d'entrée 1 par des fils d'aluminium 21 soudés à la portion annulaire la adjacente, la borne 5 et le disque 9, disposé en regard sur la face opposée du substrat diamant 4, constituant les deux bornes de l'interrupteur diamant 6.

Une telle borne métallisée 5 est par exemple obtenue sur le substrat 4 par un procédé de métallisation comportant les étapes suivantes :
- dépôt d'une résine photosensible sur la face supérieure du substrat diamant ;
- élimination de la résine en regard des surfaces à métalliser par rayonnement au travers d'un masque ;
- métallisation par vaporisation successive de Titane-Platine-Or sur la surface du substrat diamant recouverte partiellement de résine ;
- élimination de la résine restante en plongeant le substrat dans l'acétone.

La conduction électrique entre les deux bornes 5 et 9 est réalisée sur commande par la mise en route d'une source optique ultraviolette 7 disposée en regard de la borne 5, cette dernière présentant de multiples fentes 5a non métallisées, en forme d'arc de cercle, laissant passer le rayonnement émis par la source optique 7 afin d'irradier le volume de diamant 4 séparant les bornes 5 et 9 de l'interrupteur diamant 6 et provoquer ainsi la conduction électrique entre ces deux bornes. Les sources optiques 7 sont avantageusement supportées par une plaque 22, représentée en trait mixte sur la figure 1, rapportée sur des pieds 8 portés par la face supérieure du socle 3, et sont commandées indépendamment les unes des autres par un circuit de commande constituant le circuit de commande du convertisseur.

Un tel convertisseur matriciel présente l'avantage de posséder des interrupteurs diamant qui peuvent supporter de grandes tensions à leurs bornes et qui assurent naturellement une bidirectionnalité du courant au travers du convertisseur. De plus, la commande d'un tel convertisseur se fait par la commande optique des interrupteurs diamant, cette commande optique présentant l'avantage d'être naturellement isolée du potentiel électrique aux bornes de l'interrupteur. Enfin, de par sa topologie modulable grâce à la commande optique, un tel convertisseur matriciel permet tout type de conversion tel que de la conversion directe AC/AC monophasé ou triphasé, de la conversion AC/DC ou DC/DC lorsqu'il est connecté à une source de tension continue.

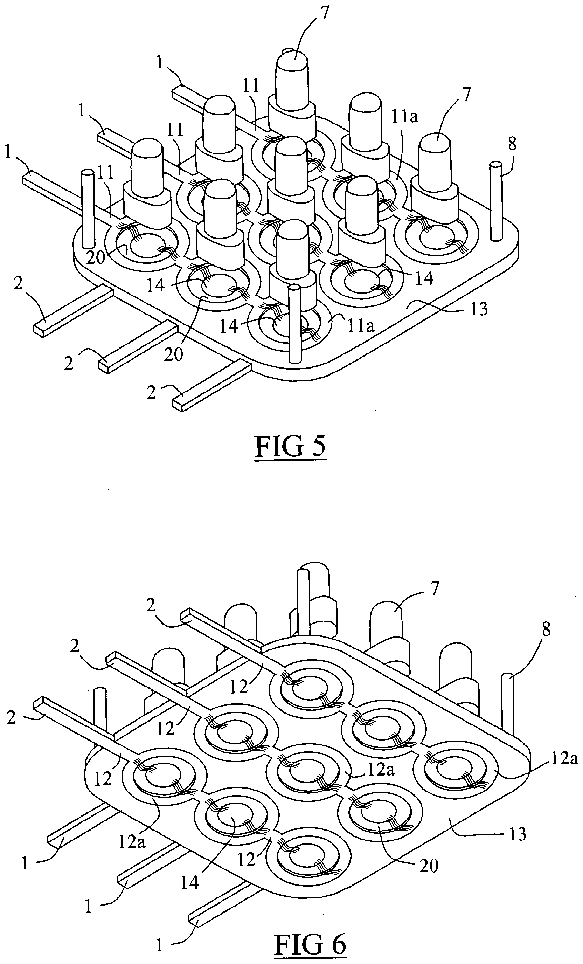

Les figures 5 à 8 représentent une réalisation du convertisseur selon l'invention. Conformément aux figures 5 et 6, le convertisseur matriciel comporte un substrat céramique 13 en nitrure d'aluminium AlN comprenant neuf trous circulaires répartie suivant une matrice 3x3, chaque trou débouchant de part et d'autre du substrat céramique 13 et recevant un substrat diamant 14 cylindrique, d'un diamètre de l'ordre de 10 mm, entouré d'une zone de verre 20.

Cette zone en verre 20, éventuellement chargée de céramique, réalise une interface entre le substrat diamant 14 et le substrat céramique 13 et présente l'avantage de posséder un coefficient de dilatation α proche de 3,5, permettant d'atténuer les efforts provoqués par la dilatation différentielle entre le diamant (α=1) et le substrat AlN (α=4,5).

Conformément à la figure 5, la face supérieure du substrat céramique 13 est munie de trois connecteurs d'entrée 1 débordant latéralement sur un bord du substrat céramique 13 et se prolongeant respectivement sur le substrat 13 par trois pistes conductrices 11 disposées en parallèles, chaque piste conductrice 11 étant alignée avec une ligne de la matrice 3x3 de substrats diamant 14. Les pistes conductrices 11 comportent chacune trois portions annulaires 11a s'étendant respectivement à la périphérie des trois substrats diamant 14 alignés avec le connecteur d'entrée 1 considéré.

Conformément à la figure 6, la face inférieure du substrat céramique 13 est munie de trois connecteurs de sortie 2 orientés perpendiculairement aux connecteurs d'entrée 1 et débordant latéralement sur un bord du substrat céramique 13. Ces trois connecteurs de sortie 2 se prolongent respectivement sur le substrat 13 par trois pistes conductrices 12 disposées en parallèles, chaque piste 12 étant alignée avec une colonne de la matrice 3x3 formées de substrats diamant 14. Les pistes conductrices des connecteurs de sortie 2 comportent chacune trois portions annulaires 12a s'étendant respectivement à la périphérie des trois substrats diamant 14 alignés avec le connecteur de sortie 2 considéré.

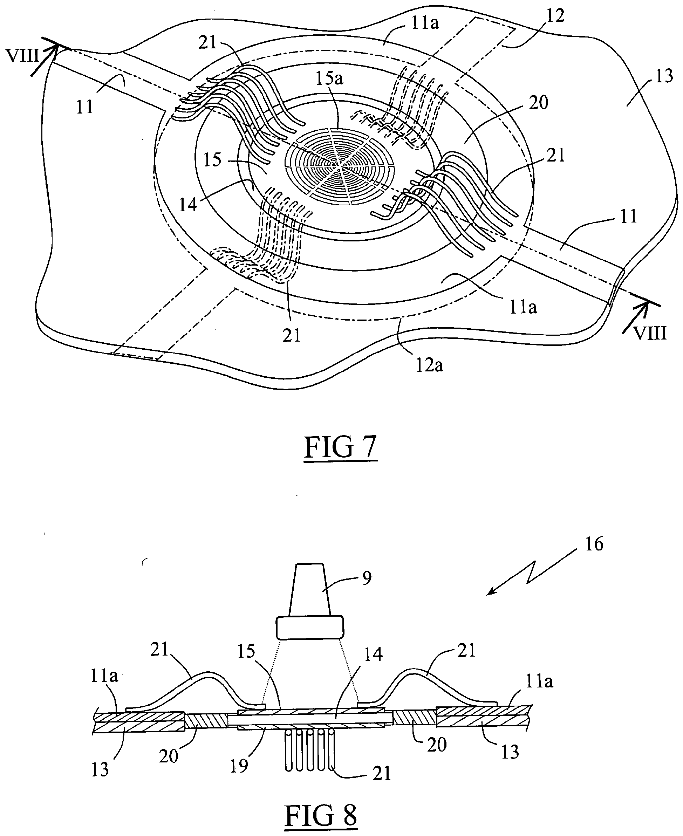

Conformément aux figures 7 et 8, chaque substrat diamant 14 comporte une face supérieure et une face inférieure recouverte respectivement sur sensiblement toute leur surface d'une borne métallisée 15 et 19, ces bornes supérieure 15 et inférieure 19, représentées uniquement sur ces figures, constituant les deux bornes d'un interrupteur diamant 16. De telles bornes métallisées 15 et 19 sont par exemple obtenues sur le substrat 14 par un procédé de métallisation comportant les étapes suivantes :
- dépôt d'une résine photosensible sur la face supérieure du substrat diamant ;
- élimination de la résine en regard des surfaces à métalliser par rayonnement au travers d'un masque ;
- métallisation par vaporisation successive de Titane-Platine-Or sur la surface du substrat diamant recouverte partiellement de résine ;
- élimination de la résine restante en plongeant le substrat dans l'acétone.

La borne supérieure 15 de chaque substrat diamant 14 est connectée par des fils d'aluminium 21 à la portion annulaire 11a de la piste conductrice 11 disposée à la périphérie du substrat diamant 14 et la borne inférieure 19 de chaque substrat diamant 14 est connectée par des fils d'aluminium 21, représentés en trait mixte sur la figure 7, à la portion annulaire 12a de la piste conductrice 12 disposée à la périphérie du substrat diamant 14.

En se référant à la figure 7, le centre de la borne supérieure 15 du substrat diamant présente de multiples fentes 15a non métallisées en forme d'arc de cercle, ces fentes 15a laissant passer le rayonnement ultraviolet émis par une source optique 7 disposée en regard du substrat diamant 14 afin de permettre l'irradiation du volume du substrat diamant 14 disposé entre les bornes supérieure 15 et inférieure 19 et provoquer ainsi une conduction électrique entre ces deux bornes. Les sources optiques 7 sont avantageusement supportées par une plaque, non représentée sur les figures, rapportée sur des pieds 8 portés par la face supérieure du socle 13, les sources optiques 7 étant commandées individuellement par un circuit de commande.

Une telle variante de réalisation présente l'avantage de nécessiter une moins grande surface de substrat diamant que le mode de réalisation de la figure 1, ce qui permet de réduire le coût de fabrication du convertisseur.

Quelque soit la variante de réalisation de l'invention, l'épaisseur du substrat diamant, réalisé par exemple par procédé CVD, sera adaptée à la tension de fonctionnement du convertisseur et pourra par exemple varier d'une épaisseur de 50 µm, pour tenir une tension entre les deux faces du substrat diamant de l'ordre de 5 kV, jusqu'à une épaisseur de 200 µm pour tenir une tension de l'ordre de 20 kV.

Le convertisseur selon l'invention peut avantageusement être utilisé pour commander un moteur de traction d'un véhicule ferroviaire à partir d'une tension caténaire, sa topologie modulable lui permettant de s'adapter par simple modification de sa commande des interrupteurs diamant à différents types de tension caténaire.

Bien entendu, l'invention n'est nullement limitée au mode de réalisation décrit et illustré qui n'a été donné qu'à titre d'exemple. Des modifications restent possibles, notamment du point de vue de la constitution des divers éléments ou par substitution d'équivalents techniques, sans sortir pour autant du domaine de protection de l'invention comme défini dans les revendications.

## Revendications

1. Convertisseur matriciel pour la transformation d'énergie électrique entre au moins une source de tension (1), notamment un réseau d'alimentation, et au moins une source de courant (2), notamment une charge, ledit convertisseur comportant une matrice d'interrupteurs (6 ; 16) reliant lesdites sources de tension (1) audites sources de courant (2), **caractérisé en ce que** lesdits interrupteurs (6, 16) comportent chacun deux bornes (5, 9 ; 15, 19) disposées dans deux plans parallèles distincts et un substrat diamant photoconducteur interposé entre lesdites deux bornes (5, 9 ; 15, 19) de l'interrupteur (6 ; 16), la commande de chaque interrupteur (6 ; 16) étant réalisée au moyen d'une source optique (7) venant irradier le substrat diamant (4, 14) interposé entre les deux bornes (5, 9 ; 15, 19) et **en ce que** chaque interrupteur (16) du convertisseur est formé par un substrat diamant individuel (14) qui est supporté par un substrat céramique support (13) par l'intermédiaire d'une couche de verre (20).

2. Convertisseur matriciel selon la revendication 1, **caractérisé en ce que** ledit substrat diamant (4 ; 14) est obtenu par un procédé CVD de dépôt chimique en phase vapeur.

3. Convertisseur matriciel selon la revendication 2, **caractérisé en ce que** les bornes (15, 19) sont réalisées par métallisation du substrat diamant par vaporisation successive de Titane-Platine-Or.

4. Convertisseur matriciel selon l'une quelconque des revendication 1 à 3, **caractérisé en ce que** ladite source optique (7) est une source ultraviolette.

5. Convertisseur matriciel selon l'une quelconque des revendications 1 à 4, **caractérisé en ce que**, pour chaque interrupteur (6 ; 16), la source optique (7) est disposée en face de l'une des deux bornes (5, 9 ; 15, 19) de l'interrupteur, ladite borne (5 ; 15) comportant au moins une ouverture (5a ; 15a) permettant le passage du rayonnement de ladite source (7) vers le substrat diamant (4 ; 14) interposé entre les deux bornes (5, 9 ; 15, 19).

6. Convertisseur matriciel selon la revendication 1, **caractérisé en ce que** chaque interrupteur (16) comporte une borne (15) reliée à une source de tension (1) par une piste conductrice (11) disposée sur une face du substrat céramique (13) et une borne (19) reliée à une source de courant (2) par des pistes conductrices (12) portées par la face opposée dudit substrat céramique (13).

7. Convertisseur matriciel selon l'une quelconque des revendications 6, **caractérisé en ce que** ledit substrat céramique (13) est en nitrure d'aluminium AIN.

## Patentansprüche

1. Matrixumrichter zur Umwandlung elektrischer Energie zwischen mindestens einer Spannungsquelle (1), vor allem einem Versorgungsnetz, und mindestens einer Stromquelle (2), vor allem einer Last, wobei der Umrichter eine Unterbrechermatrix (6; 16) aufweist, die die Spannungsquellen (1) mit den Stromquellen (2) verbindet, **dadurch gekennzeichnet, dass** die Unterbrecher (6, 16) jeweils zwei in zwei unterschiedlichen parallelen Ebenen angeordnete Klemmen (5, 9; 15, 19) und ein fotoleitendes Diamantsubstrat, das zwischen den zwei Klemmen (5, 9; 15, 19) des Unterbrechers (6; 16) angeordnet ist, aufweisen, wobei die Steuerung jedes Unterbrechers (6; 16) mit Hilfe einer optischen Quelle (7) realisiert ist, die das zwischen den zwei Klemmen (5, 9; 15, 19) angeordnete Diamantsubstrat (4, 14) bestrahlt, und dass jeder Unterbrecher (16) des Umrichters von einem individuellen Diamantsubstrat (14) gebildet ist, das von einem Keramiksubstrat (13) gestützt wird, wobei das individuelle Diamantsubstrat (14) mit dem stützenden Keramiksubstrat (13) mittels einer Glasschicht (20) verbunden ist.

2. Matrixumrichter nach Anspruch 1, **dadurch gekennzeichnet, dass** das Diamantsubstrat (4; 14) mittels eines chemischen CVD-Aufbringungsverfahrens in der Dampfphase gewonnen wird.

3. Matrixumrichter nach Anspruch 2, **dadurch gekennzeichnet, dass** die Klemmen (15, 19) mittels Metallisierung des Diamantsubstrats durch sukzessives Zerstäuben von Titan-Platin-Gold hergestellt werden.

4. Matrixumrichter nach einem der Ansprüche 1 bis 3, **dadurch gekennzeichnet, dass** die optische Quelle (7) eine Ultraviolettquelle ist.

5. Matrixumrichter nach einem der Ansprüche 1 bis 4, **dadurch gekennzeichnet, dass**, für jeden Unterbrecher (6; 16), die optische Quelle (7) gegenüber einer der zwei Klemmen (5, 9; 15, 19) des Unterbrechers angeordnet ist, wobei die Klemme (5; 15) mindestens eine Öffnung (5a; 15a) aufweist, die den Durchgang der Strahlung von der Quelle (7) zum zwischen den zwei Klemmen (5, 9; 15, 19) angeordneten Diamantsubstrat (4; 14) erlaubt.

6. Matrixumrichter nach Anspruch 1, **dadurch gekennzeichnet, dass** jeder Unterbrecher (16) eine Klemme (15) aufweist, die mit einer Spannungsquelle (1) mittels einer Leitungsbahn (11) verbunden ist, die auf einer Seite des Keramiksubstrats (13) angeordnet ist, und eine Klemme (19), die mit einer Stromquelle (2) mittels Leitungsbahnen (12) verbunden ist, die von der gegenüberliegenden Seite des Keramiksubstrats (13) getragen werden.

7. Matrixumrichter nach einem der Ansprüche 6, **dadurch gekennzeichnet, dass** das Keramiksubstrat (13) Aluminiumnitrid AlN ist.

## Claims

1. A matrix converter for converting electricity between at least one voltage source (1), in particular a supply system, and at least one current source (2), in particular a charge, said converter including a matrix of switches (6; 16) connecting said voltage sources (1) to said current sources (2), **characterized in that** said switches (6, 16) each include two terminals (5, 9; 15, 19) arranged in two separate parallel planes and a photoconductive diamond substrate inserted between said two terminals (5, 9; 15, 19) of the switch (6; 16), each switch (6; 16) being controlled using an optical source (7) radiating the diamond substrate (4, 14) inserted between the two terminals (5, 9; 15, 19), and **in that** each switch (16) of the converter is formed by an individual diamond substrate (14) that is supported by a ceramic substrate (13), said individual diamond substrate (14) being connected to the support ceramic substrate (13) via a layer of glass (20).

2. The matrix converter according to claim 1, **characterized in that** said diamond substrate (4; 14) is obtained using a chemical vapor deposition (CVD) method.

3. The matrix converter according to claim 2, **characterized in that** the terminals (15, 19) are made by metallizing the diamond substrate by successive Titanium-Platinum-Gold vaporization.

4. The matrix converter according to any one of claims 1 to 3, **characterized in that** said optical source (7) is an ultraviolet source.

5. The matrix converter according to any one of claims 1 to 4, **characterized in that**, for each switch (6; 16), the optical source (7) is arranged across from one of the two terminals (5, 9; 15, 19) of the switch, said terminal (5; 15) including at least one opening (5a; 15a) allowing the radiation to pass from said source (7) toward the diamond substrate (4; 14) inserted between the two terminals (5, 9; 15, 19).

6. The matrix converter according to claim 1, **characterized in that** each switch (16) includes a terminal (15) connected to a voltage source (1) by a conductive track (11) arranged on a face of the ceramic substrate (13) and a terminal (19) connected to a current source (2) by conducting tracks (12) supported by the opposite face of said ceramic substrate (13).

7. The matrix converter according to any one of claims 6, **characterized in that** said ceramic substrate (13) is made from aluminum nitride (AlN).
